(19) Europäisches Patentamt
European Patent Office
Office européen des brevets

(11) **EP 4 079 511 A1**

(12) **EUROPEAN PATENT APPLICATION**

(43) Date of publication:
**26.10.2022 Bulletin 2022/43**

(21) Application number: **22168566.2**

(22) Date of filing: **14.04.2022**

(51) International Patent Classification (IPC):
**B32B 5/20** (2006.01)    **B32B 15/08** (2006.01)
**B32B 15/18** (2006.01)    **B32B 15/20** (2006.01)
**B32B 27/06** (2006.01)    **B32B 27/28** (2006.01)
**C08G 73/10** (2006.01)    **H05K 1/03** (2006.01)

(52) Cooperative Patent Classification (CPC):
(C-Sets available)
**B32B 5/20; B32B 15/08; B32B 15/18; B32B 15/20;
B32B 27/065; B32B 27/281; C08G 73/1042;
C08G 73/1071; C08G 73/16; C08L 71/02;
H05K 1/036;** B32B 2250/40; B32B 2255/06;
B32B 2255/26; B32B 2255/28;          (Cont.)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **19.04.2021   JP 2021070656**

(71) Applicant: **Nitto Denko Corporation
Ibaraki-shi
Osaka 567-8680 (JP)**

(72) Inventors:
• **MISHIMA, Kei
Osaka, 567-8680 (JP)**
• **NAGAMI, Naoto
Osaka, 567-8680 (JP)**

(74) Representative: **Gill Jennings & Every LLP
The Broadgate Tower
20 Primrose Street
London EC2A 2ES (GB)**

(54) **FILM FOR METAL LAYER LAMINATE BOARD**

(57)    [Problem]
To provide a film for a metal layer laminate board in which excessive smallness of a ratio of an average pore size of a first region to an average pore size of a fifth region is suppressed despite the small average pore size in an entire thickness direction of a porous resin layer.
[Solving Means]
A film 1 for a metal layer laminate board is used for lamination of a metal layer 5. The film 1 for a metal layer laminate board includes a porous resin layer 2 and a skin layer 3 in order in a thickness direction. The porous resin layer 2 has an average pore size W in the entire thickness direction of 7.0 $\mu$m or less. The porous resin layer 2 includes a first region 11 to a fifth region 15 disposed in order in a direction away from the skin layer 3 when the porous resin layer 3 is equally divided into five in the thickness direction. A ratio (A1/A5) of an average pore size A1 of the first region 11 to an average pore size A5 of the fifth region 15 is 0.45 or more and 1 or less.

FIG. 1

**(Cont. next page)**

EP 4 079 511 A1

(52) Cooperative Patent Classification (CPC): (Cont.)
B32B 2266/0214; B32B 2270/00; B32B 2307/204;
B32B 2307/732; B32B 2457/00; B32B 2457/08

C-Sets
**C08L 71/02, C08K 5/3445, C08L 27/18,
C08L 79/08**

**Description**

TECHNICAL FIELD

The present invention relates to a film for a metal layer laminate board, to be specific, to a film for a metal layer laminate board used in lamination of a metal layer.

BACKGROUND ART

A film for a metal layer laminate board including a porous resin layer and a skin layer in order in a thickness direction has been known (ref: for example, Patent Document 1 below). The film for a metal layer laminate board is laminated on a metal layer, thereby obtaining a metal layer laminate board.

In the film for a metal layer laminate board described in Example 2 of Patent Document 1, an average pore size in the entire thickness direction of the porous resin layer is as large as about 8 $\mu$m (based on FIG. 4). Further, when the above-described porous resin layer is equally divided into five in the thickness direction, it includes a first region to a fifth region disposed in order in a direction away from the skin layer, and a ratio of an average pore size of the first region to an average pore size of the fifth region is about 0.8 and close to 1 (based on FIG. 4). That is, the average pore size of the first region is approximated to the average pore size of the fifth region.

Citation List

Patent Document

Patent Document 1: WO2018/186486

SUMMARY OF THE INVENTION

PROBLEM TO BE SOLVED BY THE INVENTION

When the metal layer laminate board is produced from the film for a metal layer laminate board, furthermore, when the metal layer laminate board is processed, the film for a metal layer laminate board may be pressed (specifically, thermally pressed) in a thickness direction.

However, when the average pore size in the entire thickness direction of the porous resin layer is large, a reduction rate of the thickness after the above-described pressing becomes excessive. Thus, there is a problem that a dielectric constant before and after the pressing greatly fluctuates.

On the other hand, when the average pore size in the entire thickness direction of the porous resin layer is reduced, the ratio of the average pore size of the first region to the average pore size of the fifth region becomes excessively small. Specifically, the above-described ratio approaches 0. Then, the average pore size of the fifth region becomes excessive with respect to the average pore size of the first region, and as a result, there is a problem that the dielectric constant before and after the pressing greatly fluctuates.

The present invention provides a film for a metal layer laminate board in which excessive smallness of a ratio of an average pore size of a first region to an average pore size of a fifth region is suppressed despite the small average pore size in an entire thickness direction of a porous resin layer.

MEANS FOR SOLVING THE PROBLEM

The present invention includes a film for a metal layer laminate board used for lamination of a metal layer including a porous resin layer and a skin layer in order in a thickness direction, wherein the porous resin layer has an average pore size in the entire thickness direction of 7.0 $\mu$m or less, the porous resin layer includes a first region to a fifth region disposed in order in a direction away from the skin layer when the porous resin layer is equally divided into five in the thickness direction, and a ratio of an average pore size of the first region to an average pore size of the fifth region is 0.45 or more and 1 or less.

EFFECT OF THE INVENTION

In the film for a metal layer laminate board of the present invention, the ratio of the average pore size of the first region to the average pore size of the fifth region is 0.45 or more, and the excessive smallness thereof is suppressed despite the average pore size in the entire thickness direction of the porous resin layer of as small as 7.0 $\mu$m or less.

Therefore, it is possible to suppress a fluctuation of a dielectric constant before and after pressing.

BRIEF DESCRIPTION OF THE DRAWINGS

FIG. 1 shows a cross-sectional view of one embodiment of a film for a metal layer laminate board of the present invention.
FIG. 2 shows a cross-sectional view of a modified example of a film for a metal layer laminate board.

DESCRIPTION OF EMBODIMENTS

<One Embodiment of Film for Metal Layer Laminate Board>

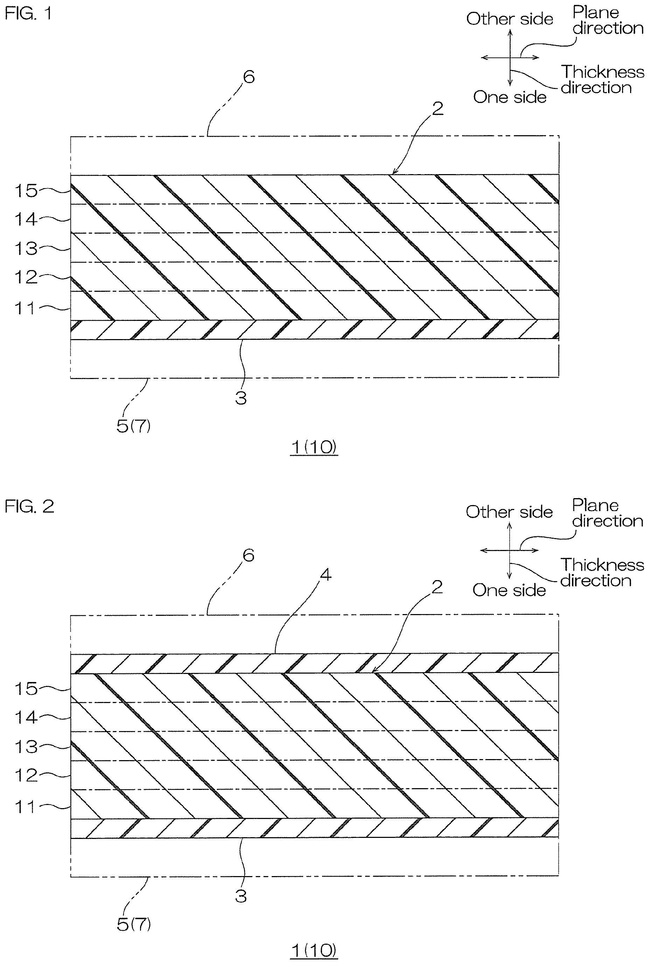

One embodiment of a film for a metal layer laminate board of the present invention is described with reference to FIG. 1. As shown in FIG. 1, a film 1 for a metal layer laminate board has a thickness, and extends in a plane direction perpendicular to a thickness direction. The thickness of the film 1 for a metal layer laminate board is not particularly limited. The film 1 for a metal layer laminate board has a dielectric constant at a frequency of 10 GHz of, for example, 2.5 or less, preferably 2.0 or less, and for example, above 1.0. The dielectric constant of the film 1 for a metal layer laminate board is measured by a dielectric resonant method. The film 1 for a metal layer laminate board has a thickness of, for example, 2 $\mu$m or more, preferably 5 $\mu$m or more, and, for example, 1000 $\mu$m or less, preferably 500 $\mu$m or less.
The film 1 for a metal layer laminate board includes a porous resin layer 2 and a skin layer 3 in order toward one side in the thickness direction.

<Porous Resin Layer 2>

The porous resin layer 2 forms the other surface in the thickness direction of the film 1 for a metal layer laminate board. The porous resin layer 2 extends in the plane direction. The porous resin layer 2 is porous. The porous resin layer 2 has a closed-cell structure and/or an open cell structure. The porous resin layer 2 has a porosity of, for example, 50% or more, preferably 60% or more, more preferably 70% or more.
The porous resin layer 2 has a porosity of, for example, below 100%, furthermore 99% or less. When the porous resin layer 2 is made of polyimide, the porosity is determined from the following formula.

$$\text{Dielectric constant of the porous resin layer } 2 = \text{dielectric constant of air} \times \text{porosity} + \text{dielectric constant of polyimide} \times (1 - \text{porosity})$$

<Average Pore Size W in Entire Thickness Direction>

The porous resin layer 2 has an average pore size W in the entire thickness direction of 7.0 $\mu$m or less. When the average pore size W in the entire thickness direction of the porous resin layer 2 is above 7.0 $\mu$m, a fluctuation rate of the thickness of the pressing is negative, and moreover, an absolute value thereof is increased on pressing (specifically, thermally pressing) the film 1 for a metal layer laminate board in the thickness direction. In other words, a reduction rate of the thickness becomes excessive. Then, the fluctuation of the dielectric constant before and after the pressing of the film 1 for a metal layer laminate board is increased.
The average pore size W in the entire thickness direction of the porous resin layer 2 is preferably 6.0 $\mu$m or less. Also, a lower limit of the average pore size W in the entire thickness direction of the porous resin layer 2 is not limited. The lower limit of the average pore size W in the entire thickness direction of the porous resin layer 2 is, for example, 0.1 $\mu$m. A calculation method of the average pore size W in the entire thickness direction of the porous resin layer 2 is described in Examples later.

<Five Equally Divided Five Regions>

The porous resin layer 2 includes a first region 11 to a fifth region 15 which are disposed in order from one surface to the other surface in the thickness direction when the porous resin layer 2 is equally divided into five in the thickness direction. More specifically, in the porous resin layer 2, the first region 11, a second region 12, a third region 13, a fourth region 14, and the fifth region 15 are disposed in order toward the other side in the thickness direction (toward a direction away from the skin layer 3 to be described later). In FIG. 1, a boundary of the regions adjacent to each other in the thickness direction is shown by a dashed line, and in the actual cross-sectional observation, the above-described boundary is not observed.

The first region 11 forms one surface in the thickness direction of the porous resin layer 2. The fifth region 15 forms the other surface in the thickness direction of the porous resin layer 2. The third region 13 is a central region in the thickness direction. The second region 12 is sandwiched between the first region 11 and the third region 13. The fourth region 14 is sandwiched between the third region 13 and the fifth region 15. The thickness of the first region 11, that of the second region 12, that of the third region 13, that of the fourth region 14, and that of the fifth region 15 are the same.

<Ratio of Average Pore Size>

A ratio (A1/A5) of an average pore size A1 of the first region 11 to an average pore size A5 of the fifth region 15 is 0.45 or more and 1.0 or less.

When the ratio (A1/A5) of the average pore size A1 of the first region 11 to the average pore size A5 of the fifth region 15 is below 0.45, the average pore size A5 of the fifth region 15 becomes excessive with respect to the average pore size A1 of the first region 11, and as a result, the dielectric constant of the film 1 for a metal layer laminate board before and after the pressing greatly fluctuates.

It is not possible that the average pore size A5 of the fifth region 15 is below the average pore size A1 of the first region 11 in a production method to be described later. Therefore, the ratio (A1/A5) of the average pore size A1 of the first region 11 to the average pore size A5 of the fifth region 15 is not above 1.0.

The ratio (A1/A5) of the average pore size A1 of the first region 11 to the average pore size A5 of the fifth region 15 is preferably 0.50 or more.

In order to set the ratio (A1/A5) of the average pore size A1 of the first region 11 to the average pore size A5 of the fifth region 15 within the above-described range, a formulation (composition) of a resin to be described next, the viscosity of a porous precursor solution, a gap of a coater, a thickness of the porous resin layer 2, and the like are adjusted.

The first region 11 has the average pore size A1 of, for example, 1.0 $\mu$m or more, preferably 2.0 $\mu$m or more, and for example, below 4.0 $\mu$m, preferably 3.5 $\mu$m or less. The fifth region 15 has the average pore size A5 of, for example, 9.0 $\mu$m or less, preferably 8.0 $\mu$m or less, and for example, 2.0 $\mu$m or more, preferably 4.0 $\mu$m or more.

The average pore size A1 of the first region 11 and the average pore size A5 of the fifth region 15 are determined by the SEM cross-sectional observation. The details of the calculation method are described in Examples later.

An example of a material for the film 1 for a metal layer laminate board includes a thermosetting resin. Examples of the thermosetting resin include polycarbonate resins, polyimide resins, fluoride polyimide resins, epoxy resins, phenol resins, urea resins, melamine resins, diallyl phthalate resins, silicone resins, thermosetting urethane resins, fluororesins (polymers of fluorine-containing olefin (specifically, polytetrafluoroethylenes (PTFE)), and liquid crystal polymers (LCP). These may be used alone or in combination of two or more. Of the above-described resins, from the viewpoint of mechanical strength, preferably, a polyimide resin is used. The details including properties and a method for producing a polyimide resin are, for example, described in WO2018/186486.

The porous resin layer 2 has a thickness of, for example, 60 $\mu$m or less, preferably 50 $\mu$m or less, more preferably 40 $\mu$m or less, and 10 $\mu$m or more, preferably 25 $\mu$m or more. When the thickness of the porous resin layer 2 is the above-described upper limit or less, the above-described ratio (A1/A5) of the average pore size can be easily set within the above-described range.

<Skin Layer 3>

The skin layer 3 is disposed on one surface in the thickness direction of the porous resin layer 2. Therefore, the first region 11 to the fifth region 15 in the porous resin layer 2 are disposed in order in a direction away from the skin layer 3 (corresponding to the other side in the thickness direction). Further, the skin layer 3 is in contact with the entire one surface in the thickness direction of the first region 11 of the porous resin layer 2. The skin layer 3 extends in the plane direction. The skin layer 3 forms one surface in the thickness direction of the film 1 for a metal layer laminate board. The skin layer 3 is substantially non-porous. The skin layer 3 has a porosity of, for example, 1% or less. A material for the skin layer 3 is not particularly limited. Preferably, the material for the skin layer 3 is the same as that for the porous resin layer 2. In this case, the skin layer 3 is integrally formed with respect to one surface in the thickness direction of the porous resin layer 2. The skin layer 3 has a thickness of, for example, 1 $\mu$m or more, and for example, 5 $\mu$m or less. A ratio of the thickness of the skin layer 3 to that of the film 1 for a metal layer laminate board is, for example, 0.01 or more and, for example, 0.2 or less.

Next, a method for producing the film 1 for a metal layer laminate board is described.

Specifically, first, a substrate film 7 made of a metal (parentheses and phantom line) is prepared. The substrate film 7 extends in the plane direction. Examples of the metal include copper, iron, silver, gold, aluminum, nickel, and alloys of these (stainless steel and bronze). As the metal, preferably, copper is used. The substrate film 7 has a thickness of, for example, 0.1 μm or more, preferably 1 μm or more, and for example, 100 μm or less, preferably 50 μm or less.

Next, a varnish containing a precursor of the above-described resin, a porosity forming agent, a nucleating agent, and a solvent is prepared, and then, the varnish is applied to one surface in the thickness direction of the substrate film 7 to form a coating film. A kind, a mixing ratio, and the like of the porosity forming agent, the nucleating agent, and the solvent in the varnish are, for example, described in WO2018/186486.

A case where the resin is a polyimide resin is described. A precursor of the polyimide resin is, for example, a reaction product of a diamine component and an acid dianhydride component. Examples of the diamine component include aromatic diamines, aliphatic diamines, and alicyclic diamines. As the diamine component, preferably, an aromatic diamine is used.

Examples of the aromatic diamine include first diamines, second diamines, and third diamines.

The first diamine includes a single aromatic ring. Examples of the first diamine include phenylenediamines, dimethylbenzenediamines, and ethylmethylbenzenediamines. From the viewpoint of mechanical strength, preferably, a phenylenediamine is used. Examples of the phenylenediamine include o-phenylenediamines, m-phenylenediamines, and p-phenylenediamines. As the phenylenediamine, preferably, a p-phenylenediamine is used.

The second diamine includes a plurality of aromatic rings and an ether bond disposed between them. An example of the second diamine includes an oxydianiline. Examples of the oxydianiline include 3,4'-oxydianiline and 4,4'-oxydianiline. From the viewpoint of mechanical strength, preferably, a 4,4'-oxydianiline is used.

The third diamine includes a plurality of aromatic rings and an ester bond disposed between them. The third diamine includes a component which increases the above-described ratio (A1/A5) in the porous resin layer 2. An example of the third diamine includes an aminophenylaminobenzoate, and preferably, a 4-aminophenyl-4-aminobenzoate is used.

In addition to the first diamine to the third diamine, examples of the aromatic diamine include 4,4'-methylenedianiline, 4,4'-dimethylenedianiline, 4,4'-trimethylenedianiline, and bis(4-aminophenyl)sulfone.

The above-described diamine components may be used alone or in combination. As the diamine component, preferably, a combination of a first diamine, a second diamine, and a third diamine is used. More preferably, a combination of a p-phenylenediamine, a 4,4'-oxydianiline, and a 4-aminophenyl-4-aminobenzoate is used.

In addition, the p-phenylenediamine may be abbreviated as PDA. The 4,4'-oxydianiline (also known as 4,4'-diaminophenyl ether) may be abbreviated as ODA. The 4-aminophenyl-4-aminobenzoate may be abbreviated as APAB.

A mole fraction of the first diamine in the diamine component is preferably 10 mol% or more, more preferably 20 mol% or more, and for example, 70 mol% or less, preferably 65 mol% or less. A mole fraction of the second diamine in the diamine component is preferably 5 mol% or more, more preferably 10 mol% or more, and for example, 40 mol% or less, preferably 30 mol% or less. A mole fraction of the third diamine in the diamine component is preferably 5 mol% or more, more preferably 10 mol% or more, and for example, 40 mol% or less, preferably 30 mol% or less.

<Acid Dianhydride Component>

The acid dianhydride component contains, for example, an acid dianhydride including an aromatic ring. An example of the acid dianhydride including an aromatic ring includes an aromatic tetracarboxylic acid dianhydride. Examples of the aromatic tetracarboxylic acid dianhydride include benzenetetracarboxylic acid dianhydride, benzophenone tetracarboxylic acid dianhydride, biphenyltetracarboxylic acid dianhydride, biphenylsulfone tetracarboxylic acid dianhydride, and naphthalenetetracarboxylic acid dianhydride.

An example of the benzenetetracarboxylic acid dianhydride includes a benzene-1,2,4,5-tetracarboxylic acid dianhydride (also known as pyromellitic acid dianhydride). An example of the benzophenone tetracarboxylic acid dianhydride includes a 3,3'-4,4'-benzophenone tetracarboxylic acid dianhydride. Examples of the biphenyltetracarboxylic acid dianhydride include 3,3'-4,4'-biphenyltetracarboxylic acid dianhydride, 2,2'-3,3'-biphenyltetracarboxylic acid dianhydride, 2,3,3',4'-biphenyltetracarboxylic acid dianhydride, and 3,3',4,4'-diphenylethertetracarboxylic acid dianhydride. An example of the biphenylsulfone tetracarboxylic acid dianhydride includes a 3,3',4,4'-biphenylsulfone tetracarboxylic acid dianhydride. Examples of the naphthalenetetracarboxylic acid dianhydride include 2,3,6,7-naphthalenetetracarboxylic acid dianhydride, 1,2,5,6-naphthalenetetracarboxylic acid dianhydride, 1,2,4,5-naphthalenetetracarboxylic acid dianhydride, and 1,4,5,8-naphthalenetetracarboxylic acid dianhydride. These may be used alone or in combination. As the acid dianhydride component, from the viewpoint of mechanical strength, preferably, a biphenyltetracarboxylic acid dianhydride is used, more preferably, a 3,3'-4,4'-biphenyltetracarboxylic acid dianhydride is used. The 3,3'-4,4'-biphenyltetracarboxylic acid dianhydride may be abbreviated as BPDA.

A ratio of the diamine component to the acid dianhydride component is adjusted so that a mole amount of amino groups (-NH$_2$) of the diamine component and a mole amount of acid anhydride groups (-CO-O-CO-) of the acid dianhydride component are, for example, an equal amount.

To prepare the precursor of the polyimide resin, the above-described diamine component, the above-described acid dianhydride component, and a solvent are blended to prepare a varnish, and the varnish is heated to prepare a precursor solution. Subsequently, a nucleating agent and a porosity forming agent are blended into the precursor solution to prepare a porous precursor solution.

The viscosity at 25°C of the porous precursor solution is appropriately set in accordance with conditions of a coater to be described next and the thickness of the precursor film. Specifically, the viscosity at 25°C of the porous precursor solution is, for example, 5 Pa·s or more, preferably 10 Pa·s or more, and for example, 100 Pa·s or less, preferably 50 Pa·s or less. The viscosity at 25°C of the porous precursor solution is measured with an E-type viscometer.

Thereafter, the porous precursor solution is applied to one surface in the thickness direction of the substrate film 7 to form a coating film. In the formation of the coating film, a coater is used. The coater is not particularly limited. Examples of the coater include gravure roll coaters, reverse roll coaters, kiss roll coaters, dip roll coaters, bar coaters, knife coaters, spray coaters, comma coaters, direct coaters, and die coaters. Preferably, a comma coater and a die coater are used. On the other hand, in the method using a die, there may be case where a coating film becomes excessively thick, which is unsuitable.

Thereafter, the coating film is dried by heating to form a precursor film. By the above-described heating, the precursor film having a phase separation structure of a polyimide resin precursor and the porosity forming agent with the nucleating agent as a core is prepared, while the removal of the solvent proceeds. In addition, a temperature of drying by the above-described heating is low, and the time of drying is short. Specifically, a drying temperature is, for example, 160°C or less. The drying time is, for example, 1000 seconds or less. By the above-described drying by heating, the skin layer 3 is formed on one surface in the thickness direction of the precursor film.

Thereafter, for example, the porosity forming agent is extracted (pulled out or removed) from the precursor film by a supercritical extraction method using supercritical carbon dioxide as a solvent.

Thereafter, the precursor film is cured by heating to form the film 1 for a metal layer laminate board made of a polyimide resin. The film 1 for a metal layer laminate board includes the skin layer 3 and the porous resin layer 2 in order toward the other side in the thickness direction. One surface in the thickness direction of the skin layer 3 is in contact with the substrate film 7.

Thereafter, if necessary, as shown by a solid line of FIG. 1, the substrate film 7 is removed. For example, the substrate film 7 is dissolved using a stripping solution. An example of the stripping solution includes $FeCl_3$. Thus, the film 1 for a metal layer laminate board is obtained. When a metal layer laminate board 10 to be described later is produced, the above-described substrate film 7 is not removed, and left as a first metal layer 5.

<Application>

Next, as shown by a phantom line of FIG. 1, the metal layer laminate board 10 including the film 1 for a metal layer laminate board is described. The metal layer laminate board 10 includes the film 1 for a metal layer laminate board and two metal layers 5 and 6 shown by the phantom line.

The film 1 for a metal layer laminate board is provided in the metal layer laminate board 10. That is, the film 1 for a metal layer laminate board is used for lamination of the two metal layers 5 and 6 to be described next.

The two metal layers 5 and 6 include the first metal layer 5 and a second metal layer 6. The first metal layer 5 is disposed on one surface in the thickness direction of the film 1 for a metal layer laminate board. Specifically, the first metal layer 5 is in contact with the entire one surface in the thickness direction of the skin layer 3. Examples of a material for the first metal layer 5 include metals illustrated in the substrate film 7. Preferably, copper is used. The first metal layer 5 has a thickness of, for example, 0.1 μm or more, preferably 1 μm or more, and for example, 100 μm or less, preferably 50 μm or less.

The second metal layer 6 is disposed on the other surface in the thickness direction of the film 1 for a metal layer laminate board. Specifically, the second metal layer 6 is in contact with the entire other surface in the thickness direction of the porous resin layer 2 (the fifth region 15). The second metal layer 6 may be also disposed on the other surface in the thickness direction of the porous resin layer 2 via an adhesive layer which is not shown. Examples of a material for the second metal layer 6 include metals illustrated in the substrate film 7. A thickness of the second metal layer 6 is the same as that of the first metal layer 5.

A method for producing the metal layer laminate board 10 is described. First, the second metal layer 6 is disposed on the other surface in the thickness direction of a laminate which is in the middle of production and includes the substrate film 7 and the film 1 for a metal layer laminate board. On the other hand, since the substrate film 7 is made of a metal, it is left as it is as the first metal layer 5 (is diverted to the first metal layer 5). Thus, the metal layer laminate board 10 including the film 1 for a metal layer laminate board, and the first metal layer 5 and the second metal layer 6 disposed on one surface and the other surface, respectively, in the thickness direction thereof is obtained.

Thereafter, the first metal layer 5 and the second metal layer 6 are, for example, formed into a pattern by etching and the like.

The metal layer laminate board 10 is pressed before, during and/or after the formation of the above-described pattern in accordance with its application and purpose. Specifically, the metal layer laminate board 10 is thermally pressed.

The metal layer laminate board 10 is, for example, used for wireless communication of the fifth generation (5G) standard, and a high-speed flexible printed board (FPC).

(Function and Effect of One Embodiment)

In the film 1 for a metal layer laminate board, even though the average pore size W in the entire thickness direction of the porous resin layer 2 is as small as 7.0 $\mu$m or less, the ratio (A1/A5) of the average pore size A1 of the first region 11 to the average pore size A5 of the fifth region 15 is 0.45 or more, and excessive smallness thereof is suppressed. Therefore, it is possible to suppress the fluctuation of the dielectric constant before and after the pressing of the film 1 for a metal layer laminate board.

(Modified Examples)

In each modified example below, the same reference numerals are provided for members and steps corresponding to each of those in the above-described one embodiment, and their detailed description is omitted. Each modified example can achieve the same function and effect as that of one embodiment unless otherwise specified. Furthermore, one embodiment and the modified example thereof can be appropriately used in combination.

The material for the substrate film 7 may be a resin. In this case, after the film 1 for a metal layer laminate board is produced, the substrate film 7 is removed, and then, if necessary, the first metal layer 5 is attached to one surface in the thickness direction of the skin layer 3 using an adhesive layer. At that time, pressing (specifically, thermal pressing) is used.

As shown in FIG. 2, the film 1 for a metal layer laminate board of the modified example includes two skin layers 3 and 4. The two skin layers 3 and 4 include the above-described skin layer 3 and a second skin layer 4. The second skin layer 4 is disposed on the other surface in the thickness direction of the porous resin layer 2. Specifically, the second skin layer 4 is in contact with the entire other surface in the thickness direction of the porous resin layer 2 (the fifth region 15). A material and a thickness of the second skin layer 4 are the same as those of the above-described skin layer 3.

Examples

Next, the present invention is further described based on Examples and Comparative Examples below. The present invention is however not limited by these Examples and Comparative Examples. The specific numerical values in mixing ratio (content ratio), property value, and parameter used in the following description can be replaced with upper limit values (numerical values defined as "or less" or "below") or lower limit values (numerical values defined as "or more" or "above") of corresponding numerical values in mixing ratio (content ratio), property value, and parameter described in the above-described "DESCRIPTION OF EMBODIMENTS".

(Example 1)

A reaction device equipped with a stirrer and a thermometer was charged with 71.37 g (0.66 mol) of PDA, 44.05 g (0.22 mol) of ODA, and 50.22 g (0.22 mol) of APAB; and 2300 g of an N-methyl-2-pyrrolidone (NMP) as a solvent was added thereto and stirred to prepare an NMP solution of PDA, ODA and APAB. The NMP solution contained 1.10 mol of a diamine component.

Next, 323.64 g (1.10 mol) of a 3,3'-4,4'-biphenyltetracarboxylic acid dianhydride (3,3'-4,4'-BPDA) was gradually added to the NMP solution of PDA, ODA, and APAB, furthermore, 331 g of an N-methyl-2-pyrrolidone (NMP) was added to increase the temperature to 80°C, and thereafter, the resulting mixture was stirred for 10 hours to obtain a polyimide precursor solution.

As a nucleating agent, 3 parts by mass of a PTFE powder having a median diameter of 1 $\mu$m or less; as a porosity forming agent, 200 parts by mass of a polyoxyethylene dimethyl ether having a weight average molecular weight of 400 (manufactured by NOF CORPORATION, grade: MM400); and 4 parts by mass of a 2-methylimidazole (manufactured by SHIKOKU CHEMICALS CORPORATION, 2Mz-H) were added to 100 parts by mass of the solid content of the polyimide precursor solution to obtain a porous precursor solution. The viscosity at 25°C of the porous precursor solution was 50 Pa·s. The porous precursor solution was applied to the substrate film 7 (the second metal layer 6) made of copper with a comma coater to form a coating film. The comma coater had two rolls which were oppositely disposed across a gap. The substrate film 7 was brought into contact with one roll, and the closest distance (gap) between the substrate film 7 and the other roll was set to 225 $\mu$m.

Thereafter, the coating film was dried at 120 to 160°C for 540 seconds to fabricate a precursor film having a thickness of about 50 $\mu$m.

By immersing the precursor film into carbon dioxide pressurized to 30 MPa at 60°C and by circulating it for eight hours, extraction removal of the porosity forming agent, phase separation of the remaining NMP, and formation of pores were promoted. Thereafter, the carbon dioxide was reduced in pressure.

Subsequently, the precursor film was subjected to heat treatment at a temperature of 300°C to 400°C for about five hours under vacuum to promote removal and imidization of the remaining component, thereby obtaining the film 1 for a metal layer laminate board disposed on one surface in the thickness direction of the substrate film 7. Thereafter, the substrate film 7 and the film 1 for a metal layer laminate board were immersed in a $FeCl_3$ solution, and the substrate film 7 was dissolved and removed. Thus, the film 1 for a metal layer laminate board including the porous resin layer 2 and the skin layer 3 was produced.

The porous resin layer 2, the skin layer 3, and the film 1 for a metal layer laminate board of Example 1 had a thickness of 40.7 $\mu$m, 3.0 $\mu$m, and 43.7 $\mu$m, respectively. The thickness of the film 1 for a metal layer laminate board was measured by a film thickness measurement device (HKT-1200, manufactured by Fujiwork Co., Ltd.). The thickness of the skin layer 3 was determined by SEM observation to be described later. The porous resin layer 2 was obtained by subtracting the thickness of the skin layer 3 from the thickness of the film 1 for a metal layer laminate board. The thickness of subsequent Examples was also obtained as described above.

The film 1 for a metal layer laminate board had a dielectric constant at a frequency of 10 GHz of 1.62. The dielectric constant was determined by a Split Post Dielectric Resonant (SPDR) method using a PNA network analyzer (manufactured by Agilent Technologies). The dielectric constant of subsequent Examples was also obtained as described above.

(Example 2)

The film 1 for a metal layer laminate board was produced in the same manner as in Example 1. However, the gap was changed to 250 $\mu$m, and the drying time was changed to 900 seconds. The porous resin layer 2, the skin layer 3, and the film 1 for a metal layer laminate board of Example 2 had a thickness of 44.9 $\mu$m, 3.9 $\mu$m, and 48.8 $\mu$m, respectively. The film 1 for a metal layer laminate board of Example 2 had a dielectric constant at a frequency of 10 GHz of 1.61.

(Example 3)

The film 1 for a metal layer laminate board was produced in the same manner as in Example 2. However, the viscosity at 25°C of the porous precursor solution was changed to 10 Pa·s by changing a formulation of the stirring time from 10 hours to 15 hours after increasing the temperature at the time of preparation of the polyimide precursor solution to 80°C. The porous resin layer 2, the skin layer 3, and the film 1 for a metal layer laminate board of Example 3 had a thickness of 42.0 $\mu$m, 3.0 $\mu$m, and 45.0 $\mu$m, respectively. The film 1 for a metal layer laminate board of Example 3 had a dielectric constant at a frequency of 10 GHz of 1.63.

(Example 4)

The film 1 for a metal layer laminate board was produced in the same manner as in Example 1. However, the gap was changed to 260 $\mu$m, and the drying time was changed to 900 seconds. The porous resin layer 2, the skin layer 3, and the film 1 for a metal layer laminate board of Example 4 had a thickness of 49.1 $\mu$m, 3.7 $\mu$m, and 52.8 $\mu$m, respectively. The film 1 for a metal layer laminate board of Example 4 had a dielectric constant at a frequency of 10 GHz of 1.65.

(Comparative Example 1)

The film 1 for a metal layer laminate board was produced in the same manner as in Example 1. However, the gap was changed to 275 $\mu$m, and the drying time was changed to 900 seconds. The film 1 for a metal layer laminate board of Comparative Example 1 had a thickness of 58.3 $\mu$m, and had a dielectric constant at a frequency of 10 GHz of 1.54.

(Comparative Example 2)

The film 1 for a metal layer laminate board was produced in the formulation of Example 2 of Patent Document 1. The porous resin layer 2, the skin layer 3, and the film 1 for a metal layer laminate board of Comparative Example 2 had a thickness of 94 $\mu$m, 6 $\mu$m, and 100 $\mu$m, respectively, and had a dielectric constant at a frequency of 10 GHz of 1.48.

<Evaluation>

The following items were evaluated for each of the films 1 for a metal layer laminate board of Examples and Comparative Examples. The results are described in Table 1.

<Average Pore Size>

An image of a secondary electron in a cross section of the film 1 for a metal layer laminate board was observed under the conditions of an acceleration voltage of 2.0 kV with an SEM (SU8020, manufactured by Hitachi, Ltd.), thereby obtaining an SEM image. From this SEM image, the first region 11 to the fifth region 15 were specified, and each of the average pore size A1 of the first region 11, the average pore size A5 of the fifth region 15, and the average pore size W in the entire thickness direction was measured twice. Each pore size was determined from measurement of the maximum pore size of the pore based on a scale bar of the SEM image. Then, the average values of the two measurement values were obtained as the average pore size A1 of the first region 11, the average pore size A5 of the fifth region 15, and the average pore size W in the entire thickness direction. In addition, a ratio (A1/A5) of the average pore size A1 of the first region 11 to the average pore size A5 of the fifth region 15 obtained as described above was also calculated.

<Thermally Pressing Properties>

A sample having a size of 40 mm× 40 mm was fabricated from the film 1 for a metal layer laminate board. The sample was set in an instantaneous vacuum lamination device VS008-1515 (manufactured by MIKADO TECHNOS CO., LTD.) and pressed at 160°C at a pressure of 5 MPa for 300 seconds. A thickness and a dielectric constant after the pressing were determined. Then, a fluctuation rate of the thickness, and a fluctuation rate of the dielectric constant before and after the pressing were determined based on the following formula.

$$\text{Fluctuation rate (\%) of thickness before and after pressing} = (\text{thickness after pressing} - \text{thickness before pressing})/ \text{thickness before pressing} \times 100$$

$$\text{Fluctuation rate (\%) of dielectric constant before and after pressing} = (\text{dielectric constant after pressing} - \text{dielectric constant before pressing})/ \text{dielectric constant before pressing} \times 100$$

[Table 1]

Table 1

| | | Ex. 1 | Ex. 2 | Ex. 3 | Ex. 4 | Comparative Ex. 1 | Comparative Ex. 2[*1] |
|---|---|---|---|---|---|---|---|
| Production Conditions | Viscosity of Porous Precursor Solution (Pa·s)(25°C) | 50 | 50 | 10 | 50 | 50 | 20 |
| | Gap in Coater (μm) | 225 | 250 | 250 | 260 | 275 | (Die Method) |
| | Drying Time of Coating Film (sec) | 540 | 900 | 900 | 540 | 900 | 1800[*2] |
| Thickness (μm) | Film for Metal Layer Laminate Board | 43.7 | 48.8 | 45.0 | 52.8 | 58.3 | 100 |
| | Porous Resin Layer | 40.7 | 44.9 | 42.0 | 49.1 | 56.0 | 94 |

(continued)

| | | Ex. 1 | Ex. 2 | Ex. 3 | Ex. 4 | Comparative Ex. 1 | Comparative Ex. 2*1 |
|---|---|---|---|---|---|---|---|
| Average Pore Size of Porous Resin Layer ($\mu$m) | Entire Thickness Direction | 4.1 | 4.5 | 4.9 | 4.0 | 7.1 | 8 |
| | First Region | 3.1 | 3.3 | 3.5 | 2.29 | 4.0 | 7.7 |
| | Fifth Region | 5.5 | 6.3 | 7.5 | 4.7 | 9.5 | 9.4 |
| | First Region/Fifth Region | 0.56 | 0.53 | 0.47 | 0.62 | 0.42 | 0.82 |
| Fluctuation Rate of Thickness Before and After Pressing (%) | | -1.6 | -2.6 | -2.8 | -0.4 | -4.5 | -36.5 |
| Fluctuation Rate of Dielectric Constant Before and After Pressing (%) | | 0.6 | 1.2 | 1.2 | 0 | 1.9 | 18 |
| *1: Corresponding to Ex. 2 of WO2018/186486 *2: 120°C | | | | | | | |

While the illustrative embodiments of the present invention are provided in the above description, such is for illustrative purpose only and it is not to be construed as limiting the scope of the present invention. Modification and variation of the present invention that will be obvious to those skilled in the art is to be covered by the following claims.

Description of Reference Numerals

1    Film for metal layer laminate board
2    Porous resin layer
3    Skin layer
4    Second skin layer
5    First metal layer
6    Second metal layer
10    Metal layer laminate board
11    First region
15    Fifth region

**Claims**

1.  A film for a metal layer laminate board used for lamination of a metal layer comprising:

a porous resin layer and a skin layer in order in a thickness direction, wherein
the porous resin layer has an average pore size in the entire thickness direction of 7.0 $\mu$m or less,
the porous resin layer includes a first region to a fifth region disposed in order in a direction away from the skin layer when the porous resin layer is equally divided into five in the thickness direction, and
a ratio of an average pore size of the first region to an average pore size of the fifth region is 0.45 or more and 1 or less.

FIG. 1

Other side / Plane direction

Thickness direction

One side

6

2

15
14
13
12
11

3

5(7)

1(10)

FIG. 2

Other side / Plane direction

Thickness direction

One side

6

4

2

15
14
13
12
11

3

5(7)

1(10)

Europäisches
Patentamt

European
Patent Office

Office européen
des brevets

# EUROPEAN SEARCH REPORT

Application Number

EP 22 16 8566

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2019/263996 A1 (NAKAMURA MASAYOSHI [JP] ET AL) 29 August 2019 (2019-08-29) <br> * paragraph [0023] - paragraph [0026] * <br> * paragraph [0040] - paragraph [0041] * <br> * example 1 * <br> * table 1 * <br> * claim 12 * <br> ----- | 1 | INV. <br> B32B5/20 <br> B32B15/08 <br> B32B15/18 <br> B32B15/20 <br> B32B27/06 <br> B32B27/28 <br> C08G73/10 <br> H05K1/03 |
| X | US 2019/263995 A1 (NAKAMURA MASAYOSHI [JP] ET AL) 29 August 2019 (2019-08-29) <br> * paragraph [0023] - paragraph [0026] * <br> * paragraph [0031] * <br> * paragraph [0084] * <br> * example 5 * <br> * claims 1-10 * <br> ----- | 1 | |
| X | US 2014/127494 A1 (YAKUWA SHINPEI [JP] ET AL) 8 May 2014 (2014-05-08) <br> * paragraph [0019] * <br> * paragraph [0024] - paragraph [0026] * <br> * paragraph [0060] - paragraph [0061] * <br> * table 1 * <br> ----- | 1 | |

TECHNICAL FIELDS
SEARCHED      (IPC)

B32B
C08G
C09J
H05K

The present search report has been drawn up for all claims

| Place of search | Date of completion of the search | Examiner |
|---|---|---|
| The Hague | 7 September 2022 | Sanchez Perucha, A |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons
.......................................................................
& : member of the same patent family, corresponding
    document

EPO FORM 1503 03.82 (P04C01)

EP 4 079 511 A1

## ANNEX TO THE EUROPEAN SEARCH REPORT
## ON EUROPEAN PATENT APPLICATION NO.

EP 22 16 8566

07-09-2022

| Patent document cited in search report | | Publication date | Patent family member(s) | | Publication date |
|---|---|---|---|---|---|
| US 2019263996 | A1 | 29-08-2019 | CN | 109496222 A | 19-03-2019 |
| | | | EP | 3489288 A1 | 29-05-2019 |
| | | | JP | 6567590 B2 | 28-08-2019 |
| | | | JP | 2018021171 A | 08-02-2018 |
| | | | JP | 2019199614 A | 21-11-2019 |
| | | | KR | 20190029649 A | 20-03-2019 |
| | | | KR | 20210071103 A | 15-06-2021 |
| | | | TW | 201811884 A | 01-04-2018 |
| | | | TW | 201936741 A | 16-09-2019 |
| | | | US | 2019263996 A1 | 29-08-2019 |
| | | | WO | 2018020745 A1 | 01-02-2018 |
| US 2019263995 | A1 | 29-08-2019 | CN | 109496223 A | 19-03-2019 |
| | | | EP | 3489292 A1 | 29-05-2019 |
| | | | JP | 6567591 B2 | 28-08-2019 |
| | | | JP | 2018021172 A | 08-02-2018 |
| | | | JP | 2019199615 A | 21-11-2019 |
| | | | JP | 2021152165 A | 30-09-2021 |
| | | | KR | 20190027887 A | 15-03-2019 |
| | | | TW | 201810753 A | 16-03-2018 |
| | | | TW | 202029544 A | 01-08-2020 |
| | | | US | 2019263995 A1 | 29-08-2019 |
| | | | WO | 2018020746 A1 | 01-02-2018 |
| US 2014127494 | A1 | 08-05-2014 | CN | 103597016 A | 19-02-2014 |
| | | | JP | 5916498 B2 | 11-05-2016 |
| | | | JP | 2013014742 A | 24-01-2013 |
| | | | KR | 20140025569 A | 04-03-2014 |
| | | | US | 2014127494 A1 | 08-05-2014 |
| | | | WO | 2012169383 A1 | 13-12-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2018186486 A